(19) Europäisches Patentamt
European Patent Office
Office européen des brevets

(11) **EP 1 260 016 B1**

(12) **EUROPÄISCHE PATENTSCHRIFT**

(45) Veröffentlichungstag und Bekanntmachung des Hinweises auf die Patenterteilung:
**24.01.2007 Patentblatt 2007/04**

(21) Anmeldenummer: **01919156.8**

(22) Anmeldetag: **02.03.2001**

(51) Int Cl.:
***H03F 1/32*** *(2006.01)*

(86) Internationale Anmeldenummer:
**PCT/DE2001/000786**

(87) Internationale Veröffentlichungsnummer:
**WO 2001/065683 (07.09.2001 Gazette 2001/36)**

(54) **VERFAHREN UND SENDESCHALTUNG ZUR ERZEUGUNG EINES SENDESIGNALS**

METHOD AND TRANSMISSION CIRCUIT FOR GENERATING A TRANSMISSION SIGNAL

PROCEDE ET CIRCUIT D'EMISSION PERMETTANT DE GENERER UN SIGNAL D'EMISSION

(84) Benannte Vertragsstaaten:
**DE FR GB**

(30) Priorität: **03.03.2000 DE 10010635**

(43) Veröffentlichungstag der Anmeldung:
**27.11.2002 Patentblatt 2002/48**

(73) Patentinhaber: **SIEMENS AKTIENGESELLSCHAFT**
**80333 München (DE)**

(72) Erfinder:
• **KUECHLER, Heinz**
**81477 Muenchen (DE)**
• **MOLIERE, Thomas**
**80805 Muenchen (DE)**
• **SEVILLA GARCIA, José**
**E-30840 Alhama, Murcia (ES)**
• **WILHELM, Hartmut**
**81477 Muenchen (DE)**

(56) Entgegenhaltungen:
**EP-A- 0 558 793**     **WO-A-86/00476**
**DE-A- 4 429 535**     **FR-A- 2 532 491**

EP 1 260 016 B1

**Beschreibung**

Die Erfindung betrifft ein Verfahren zur Erzeugung eines amplitudenmodulierten Sendesignals mit einer einstellbaren mittleren Sendeleistung, bei dem ein Amplitudenmodulationssignal an einen Eingang eines Sendeverstärkers angelegt wird und bei dem das Amplitudenmodulationssignal unter Nutzung eines rückgekoppelten Anteils des Sendesignals geregelt wird. Darüber hinaus betrifft die Erfindung eine entsprechende Schaltung sowie ein Kommunikationsendgerät mit einer solchen Schaltung.

Bei den meisten Sendern ist es erforderlich, dass sich die Sendeleistung an die erforderliche Reichweite und ggf. an die Funkbedingungen in der jeweiligen Umgebung des Senders bzw. Empfängers anpassen lässt. Bei dem Mobilfunkstandard GSM gibt es dafür den sogenannten "Power Control Level". Hiermit wird die mittlere Sendeleistung des auszusendenden Signals, der "Sendeleistungspegel", eingestellt. Weiterhin wird zur Vermeidung von durch einen burstweisen Betrieb hervorgerufenen Nachbarkanalstörungen die Sendeleistung zu Burstbeginn langsam von Null auf den Zielwert gebracht und am Burstende langsam heruntergefahren. Dieses sogenannte "Power ramping" und der Power Control Level sind Beispiele für die im Folgenden verwendeten Ausdrücke mittlere Sendeleistung, Sendeleistungspegel oder Sendeleistungsstufe. Diese Ausdrücke sind nicht darauf beschränkt, dass die Einstellung stufenweise erfolgt, sondern es ist auch eine wertkontinuierliche Leistungseinstellung möglich. Ebenso ist die nachfolgend beschriebene Erfindung nicht auf Mobilfunkanwendungen beschränkt.

Bei einem amplitudenmodulierten Signal hängt die zu einem bestimmten Zeitpunkt vorliegende momentane Sendeleistung von der aktuellen Amplitude des Signals ab. Die Umsetzung der zu übertragenden Informationen in die Amplitudenmodulation erfolgt in der Regel so, dass für bestimmte Informationsketten in einer Steuerung digitale Abtastwerte für die Amplitude ermittelt werden und diese digitalen Abtastwerte dann verwendet werden, um ein analoges Amplitudenmodulationssignal zu erzeugen. Für die verschiedensten Ketten von Informationen (z.B. Sendedaten) sind dabei jeweils die Abtastwerte beispielsweise in einem ROM-Speicher in einer Tabelle hinterlegt. Hierbei sind aus Gründen der Speicherplatzersparnis nur die Abtastwerte für eine genau definierte mittlere Sendeleistung gespeichert. Je nach geforderter mittlerer Sendeleistung werden daher aus diesen Abtastwerten durch eine passende Skalierung die Abtastwerte für die gewünschte mittlere Leistung berechnet. Die so berechneten bzw. skalierten Abtastwerte werden daher genutzt, um die Amplitudenmodulation zu erzeugen.

Üblicherweise wird das Amplitudenmodulationssignal unter Nutzung eines rückgekoppelten Anteils des Sendesignals geregelt, um ein stabiles, reines Amplitudenmodulationssignal zu erhalten. In die Regelung gehen die Abtastwerte oder davon abgeleitete Werte als Soll-Werte ein. Die Soll-Werte werden mit dem am Ausgang des Sendeverstärkers abgezweigten Teil des Sendesignals, welches den aktuellen Ist-Wert darstellt, verglichen, und der Sendeverstärker, im Folgenden auch Endstufe genannt, wird entsprechend nachgeregelt. Die Dynamik im Soll-Signal setzt sich dabei zusammen aus der Dynamik der Amplitudenmodulation selbst und dem Bereich der möglichen einstellbaren Sendeleistung. Beim EDGE-Standard beträgt die Dynamik der Amplitudenmodulation 17 dB und die Sendeleistung ist über einen Bereich von 27 dB einstellbar. Die Gesamtdynamik beträgt daher 44 dB. Die gleiche Dynamik tritt auch im Ist-Signal auf. Sie muss von der Rückkopplung bzw. Regelschleife verarbeitet werden können. Bei anderen Übertragungsverfahren, z. B. beim CDMA-Standard kann die Anforderung an die Dynamik noch größer sein.

Eine derart große Dynamik erfordert eine aufwendige Schaltung zur Linearisierung der Kennlinien der in der Regelschleife benötigten Bauteile. Außerdem wird dadurch für eine ggf. zusätzliche Phasenregelungsschleife, um bei einer Erzeugung eines winkel- und amplitudenmodulierten Sendesignals das Sendesignal zur Regelung des winkelmodulierten Signalanteils zurückzuführen, eine sehr leistungsfähige Begrenzerschaltung benötigt.

Die WO 86 00476 A offenbart ein Verfahren und eine Vorrichtung zur Erzeugung eines amplitudenmodulierten Sendesignals mit einer einstellbaren mittleren Sendeleistung, bei dem bzw. der ein Amplitudenmodulationssignal an einen Eingang eines Sendeverstärkers angelegt wird und bei dem das Amplitudenmodulationssignal unter Nutzung eines rückgekoppelten Anteils des Sendesignals geregelt wird, wobei der rückgekoppelte Anteil des Sendesignals entsprechend der gewünschten mittleren Sendeleistung gedämpft zur Regelung genutzt wird.

Es ist Aufgabe der vorliegenden Erfindung, ein Verfahren und eine Schaltung anzugeben, um bei verminderter Anforderung an die Dynamik die Stabilität stets beizubehalten und den Einsatz einfacher und kostengünstiger Bauelemente zu ermöglichen.

Diese Aufgabe wird durch ein Verfahren gemäß Patentanspruch 1 und durch eine Sendeschaltung gemäß Patentanspruch 19 gelöst.

Erfindungsgemäß wird hierbei der rückgekoppelte Anteil des Sendesignals entsprechend der gewünschten mittleren Sendeleistung gedämpft und zur Regelung benutzt, d. h. die Einstellung der mittleren Sendeleistung erfolgt durch eine veränderliche Dämpfung zwischen dem Sendeverstärker und dem Vergleicher im Regelkreis. Eine variable Dämpfung im Sinne dieser Erfindung umfasst nicht nur eine variable Abschwächung des Signals, sondern schließt auch eine variable Verstärkung ausdrücklich ein. Wenn der Sendeverstärker eine Verstärkung < 1 macht, also das Signal abschwächt, ist es je nach der Leistung, die für die Bestimmung der Amplitude im Rückkopplungszweig nötig ist, sogar erforderlich, das Sendesignal im Rückkopplungszweig zu verstärken.

Durch die Dämpfung entsprechend der gewünschten mittleren Sendeleistung bleibt die mittlere Leistung im rückgekoppelten Signal konstant. Das heißt, bei hoher Sendeleistung wird das rückgekoppelte Signal kräftig gedämpft und bei niedriger Sendeleistung wird das Signal unter Umständen sogar ungedämpft durchgelassen, und im rückgekoppelten Anteil verbleibt nur die modulationsbedingte Amplitudenänderung mit einer konstanten mittleren Leistung. Diese wird dann in ihrer aktuellen Amplitude gemessen und mit dem Sollwert verglichen.

Wenn eine höhere mittlere Sendeleistung erforderlich ist, wird von einer geeigneten Steuerung eine höhere Dämpfung eingestellt. Da sich dadurch die Differenz zwischen Ist- und Soll-Wert ändert, wird in der Regelschleife automatisch das zum Sendeverstärker gehende Amplitudenmodulationssignal so lange erhöht, bis das Differenzsignal wieder Null ist, d. h. es wird automatisch eine höhere Sendeleistung ausgegeben. Umgekehrt wird, wenn ein niedrigerer Sendeleistungspegel eingestellt werden soll, die Dämpfung im rückgekoppelten Anteil des Sendesignals verringert, und am Vergleicher ergibt sich eine zu hohe Ist-Amplitude, bis der Regelkreis den Sendeleistungspegel abgesenkt hat.

Die Einstellung der Dämpfung kann auf verschiedenste Weisen durchgeführt werden.

Eine Möglichkeit besteht darin, ein variables Dämpfungsglied zu verwenden. Eine solche variable Dämpfung kann beispielsweise durch einen steuerbaren Spannungsteiler oder durch eine variable Auskopplungsdämpfung, d. h. ein Auskopplungselement mit einstellbarer Dämpfung, erzielt werden.

Alternativ kann auch eine Kombination von dämpfenden und verstärkenden Bauelementen verwendet werden, von denen zumindest eines der Bauelemente einstellbar sein muss. Die gleiche Wirkung wie ein variables Dämpfungsglied hat nämlich eine variable Verstärkung, die mit einer festen oder variablen Dämpfung vor und/oder nach der Verstärkung kombiniert ist. Vor der Verstärkung lässt sich auch eine passende feste Dämpfung beispielsweise durch Verwendung eines Auskopplungselements mit einer solchen festen Dämpfung erzielen. In der Regel ist die Auskopplung des rückgekoppelten Anteils des Sendesignals ohnehin mit einer relativ starken Dämpfung verbunden, so dass oftmals eine Verstärkung im Rückkopplungszweig erforderlich ist. In diesem Fall kann folglich entweder ein variabler Verstärker verwendet werden oder es wird eine feste Verstärkung mit einem variablen Dämpfungselement genutzt.

Bei einem besonders bevorzugten Ausführungsbeispiel sind das Dämpfungsglied oder das einstellbare Bauelement bzw. Auskoppelelement so aufgebaut, dass sie mehrere diskrete Einstellstufen aufweisen. Das heißt, es wird stufenweise die Dämpfung eingestellt. Ein stufenweise einstellbares Dämpfungsglied ist ein relativ einfaches Bauelement, das mit großer Genauigkeit hergestellt werden kann. Auch präzise, stufenweise einstellbare Verstärker sind im Handel erhältlich.

Sofern die Skalierung der Abtastwerte für die Amplitude einfacher ist als ein Dämpfen des rückgekoppelten Signals in sehr feinen Schritten, kann auch eine Kombination aus beiden Verfahren genutzt werden. Es wird dann eine Dämpfung in wenigen groben Stufen gemäß der Erfindung durchgeführt, und in Verbindung damit werden zur Feineinstellung die Abtastwerte für die Amplitude in einen geringeren Bereich skaliert. Auch auf diese Weise wird die Dynamik im Rückkopplungszweig erheblich begrenzt, wobei mit einfachen Mitteln aber eine sehr feine Einstellung möglich ist.

Bei einem weiteren vorteilhaften Ausführungsbeispiel wird außerdem die Dämpfung nicht einfach gesteuert, sondern geregelt. Hierzu kann ein spezieller kleiner Regelkreis verwendet werden, in dem beispielsweise einfach ein Vergleich der mittleren Leistung vor und hinter dem jeweiligen Dämpfungsmittel/Verstärker durchgeführt wird. Es reicht hier eine zusätzliche Amplitudenmessung oder eine Leistungsmessung vor den Dämpfungsmitteln/Verstärkern aus. Diese Messung kann mit einer relativ niedrigen Grenzfrequenz ausgeführt werden.

Vorzugsweise wird zum Auskoppeln von Leistung aus dem Sendesignal ein zwischen der Sendeverstärkereinheit und der Antenne angeordnetes Koppelelement verwendet. Insbesondere ist es vorteilhaft, hier ein Koppelelement zu verwenden, das vor allem die zur Antenne hinlaufende Welle erfasst und die von der Antenne reflektierte Welle unterdrückt, d. h. einen sog. Richtkoppler.

Sofern der Anteil der Leistung, der in die Rückkopplung fließt, nicht vernachlässigt werden kann, insbesondere wenn die Höhe der Dämpfung durch die Auskopplung den für die Antenne verbleibenden Leistungsanteil signifikant beeinflusst, sollte vorzugsweise dieser Umstand bei der Gestaltung der Höhe der Dämpfungsstufen berücksichtigt werden.

Bei einem weiteren bevorzugten Ausführungsbeispiel wird das entsprechend der mittleren Sendeleistung gedämpfte rückgekoppelte Signal einem regelbaren Verstärker zugeführt, der in einem weiteren Regelkreis die Amplitude des rückgekoppelten Signals auf einen Festwert, welcher durch einen Referenzwert vorgegeben werden kann, regelt. Dieses Verfahren ist immer dann möglich, wenn Modulationsarten verwendet werden, bei denen die Amplitude nicht Null wird. Erforderlich ist hierzu ein innerhalb des eingeschränkten Dynamikbereiches regelbarer Verstärker mit ausreichend linearem Zusammenhang zwischen dem Logarithmus der Verstärkung und der Regelspannung . Die Regelspannung innerhalb der zweiten Regelschleife für den regelbaren Verstärker ist dann negativ proportional zum Logarithmus der Ausgangsamplitude des Sendeverstärkers und kann als Ist-Wert in der Regelschleife für den Sendeverstärker verwendet werden. Durch eine solche Schaltung werden insbesondere die Anforderungen an den Hüllkurvendetektor, welcher sich nun innerhalb der Regelschleife hinter dem regelbaren Verstärker befindet, weiter reduziert. Außerdem steht für eine ggf. zusätzlich benötigte Regelungsschleife für das winkelmodulierte Signal ein Signal als Ist-Signal zur Verfügung, das überhaupt nicht mehr amplitudenmoduliert ist.

Um bei der Erzeugung eines amplituden- und winkelmodulierten Sendesignals, wie es beispielsweise bei heutigen Mobilfunkstandards erforderlich ist, bei möglichst guter Linearität des Sendeverstärkers ein Sendesignal mit hoher Sendeleistung zu erzeugen, ist es dem Fachmann allgemein bekannt, das zu sendende Signal nach Amplitude und Phase zu trennen und am Signaleingang des Sendeverstärkers nur das die Winkelmodulation tragende Signal, d. h. ein winkelmoduliertes Eingangssignal, anzulegen und mittels des Sendeverstärkers über mindestens einen weiteren Eingang, beispielsweise den Eingang für die Versorgungsspannung oder einen Eingang für die Transistorvorspannung, das Amplitudenmodulationssignal dem winkelmodulierten Eingangssignal aufzuprägen. Dabei wird darauf geachtet, dass das winkelmodulierte Eingangssignal und das Amplitudenmodulationssignal zeitlich so zueinander passend angelegt werden, dass die ursprüngliche Signalform wieder entsteht. Dieses Verfahren wird derzeit für eine Verstärkung von bereits kombinierten amplituden- und winkelmodulierten Signalen verwendet. Es wird dann aus dem amplituden- und winkelmodulierten Signal zunächst die Hüllkurve, d. h. die Amplitudeninformation, entfernt und die Signale werden getrennt und wie beschrieben auf den Sendeverstärker gegeben, so dass dort das Gesamtsignal wiederhergestellt wird. Das Verfahren wird daher allgemein auch mit "Envelope Elimination and Restoration" (EER) bezeichnet. Das Verfahren hat den Vorteil, dass das winkelmodulierte Eingangssignal eine konstante Amplitude aufweist und der Sendeverstärker somit genau auf diese Amplitude wirkungsgradoptimiert werden kann und beispielsweise in Sättigung betrieben werden kann. Das Amplitudenmodulationssignal kann separat geeignet verstärkt werden, so dass insgesamt ein sehr hoher Wirkungsgrad erreicht werden kann. Dies setzt selbstverständlich voraus, dass das Amplitudenmodulationssignal, d. h. die schwankende Versorgungsspannung bzw. Vorspannung des Sendeverstärkers ihrerseits mit gutem Wirkungsgrad und guter Linearität erzeugt werden kann und so ein reines und ausreichend hohes Amplitudenmodulationssignal vorliegt.

Sofern die Amplitudeninformation und die Winkelinformation getrennt vorliegen, können das winkelmodulierte Eingangssignal und das Amplitudenmodulationssignal auch getrennt erzeugt werden. In diesem Fall ist eine Elimination nicht mehr notwendig, sondern die einzelnen Bestandteile werden separat bearbeitet (z. B. gesteuert oder, wie vorliegend, geregelt) und erst am Sendeverstärker zusammengeführt. In den hier aufgeführten Ausführungsbespielen wird von der Verwendung einer solchen Schaltung ausgegangen. Dennoch ist die Erfindung nicht auf diese spezielle Art der Signalerzeugung beschränkt.

Unter Winkelmodulation ist im Übrigen der Oberbegriff für eine Phasen- und Frequenzmodulation zu verstehen. Der Begriff "Winkel" steht dabei stellvertretend für die Größen "Phase" oder "Momentanfrequenz", d. h. die zeitliche Ableitung der Phase.

Bei einem solchen Verfahren, bei dem das Amplitudenmodulationssignal über den Versorgungsspannungseingang oder einen Vorspannungseingang des Sendeverstärkers auf ein Eingangssignal aufmoduliert wird, kann die Ausgangsspannung des Sendeverstärkers eine nichtlineare Funktion der Versorgungsspannung, d. h. der aktuellen Amplitude des Amplitudenmodulationssignals, sein. "Nichtlineare Funktion" bezeichnet innerhalb dieser Schrift einen derartigen Zusammenhang. Hierzu wird auf die beiliegende Figur 4 verwiesen, die die Amplitude der Ausgangsspannung in Volt (umgerechnet auf einen Abschluss von 50 Ohm) in Abhängigkeit von der Versorgungsspannung der Endstufe in Volt aufzeigt. Es handelt sich hierbei um eine dreistufige 6 Volt-Sendeendstufe für ein Hochfrequenzsignal von 900 MHz. Wie sich in dieser Graphik zeigt, weist die nichtlineare Funktion an jedem Punkt eine andere Steigung auf. Das hat zur Folge, dass die Übertragungsfunktion des gesamten Regelkreises, welcher die Sendeendstufe umfasst, für jede Ausgangsspannung eine andere Charakteristik hat.

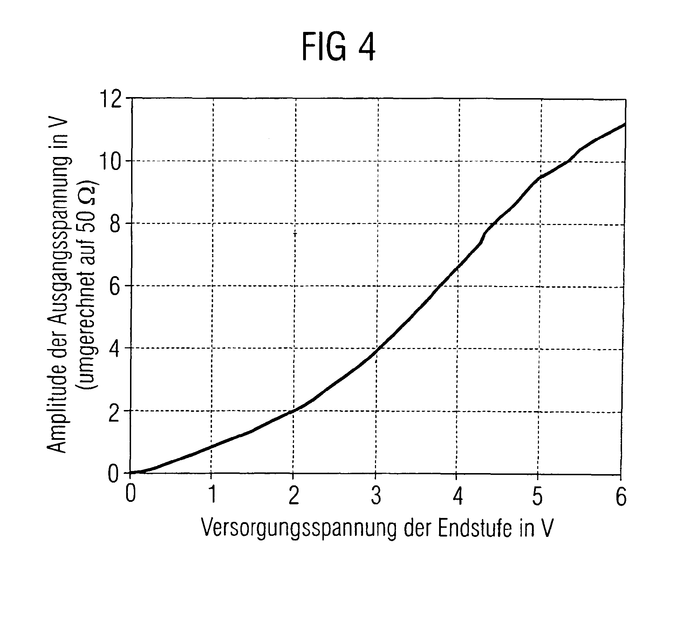

Wegen des nichtlinearen Verhaltens hängt folglich die differenzielle Verstärkung im Amplitudenpfad und damit auch die Stabilität und der Frequenzgang sowie die Gruppenlaufzeit von der Momentanamplitude ab. Um die unterschiedliche differenzielle Verstärkung, wie sie sich in der Figur 4 darstellt, im Vorwärtszweig der Regelung des Amplitudenpfads auszugleichen, ist es sinnvoll, die Verstärkung, vorzugsweise im Vorwärtszweig der Amplitude, anzupassen. Eine solche Korrekturverstärkung, jeweils passend zum aktuellen Momentanwert der Amplitudenmodulation, ist jedoch nicht einfach zu realisieren.

Sofern sich also die Steigung in dem Amplitudenbereich, der bei der gewünschten Sendeleistungsstufe von der Amplitudenmodulation überstrichen wird, nicht zu stark ändert, bietet es sich an, einen Kompromisswert, beispielsweise die Steigung am Punkt der mittleren Sendeleistung, für die Korrekturverstärkung im Vorwärtszweig zu wählen.

Bei einem besonders bevorzugten Ausführungsbeispiel wird daher eine nichtlineare Funktion des Regelkreises für das Amplitudenmodulationssignal, beispielsweise bedingt durch die Nichtlinearität der Endstufe, jeweils in einem Bereich um eine eingestellte mittlere Sendeleistung linearisiert. Das heißt, es wird lediglich bereichsweise bzw. stufenweise eine Linearisierung oder Anpassung durchgeführt. Die Linearisierung erfolgt dabei so, dass beispielsweise an einem Punkt der gewünschten mittleren Sendeleistung die lokale Steigung, d. h. die Steigung der Tangente an diese nichtlineare Funktion, ermittelt wird und entsprechend über geeignete zusätzliche Verstärker und/oder Regler die Gesamtverstärkung so eingestellt wird, dass eine Gesamtverstärkung innerhalb des Regelkreises entsprechend dieser Steigung erzielt wird. Auf diese Weise wird folglich abschnittsweise die Nichtlinearität der Funktion des Regelkreises kompensiert. Sofern die Amplitude nicht zu stark um die mittlere Sendeleistung schwankt, ist dies eine relativ gute Näherung.

So wird bei einem gegebenen Sendeleistungspegel ein ausreichend reines Sendesignal erzielt. Vorzugsweise wird beim Wechsel des Sendeleistungspegels diese Korrekturverstärkung angepasst. Alternativ kann anstelle der Steigung am Punkt der gewünschten mittleren Sendeleistung auch die Steigung an einer Momentanamplitude oder die Steigung am Ort eines Mittelwerts der Amplitude verwendet werden, wobei die zeitliche Ermittlung über eine kürzere oder längere Zeit erfasst werden kann. Die Dauer der Ermittlung kann dabei auch davon abhängen, wie lange sich die Amplitude in einem Bereich bewegt, in dem sich die nichtlineare Funktion des Regelkreises bzw. des Sendeverstärkers mit einer für das Ausgangssignal ausreichenden Genauigkeit linearisieren lässt.

Die dabei betrachtete Amplitude kann die Soll- und/oder die Ist-Amplitude sein. Sofern der Sollwert von einem Logikteil ohnehin digital ausgegeben wird, eignet sich dieser Wert natürlich besser.

Durch ein solches Verfahren der bereichsweisen bzw. abschnittsweisen Linearisierung der nichtlinearen Funktion des Regelkreises werden auf einfache Weise die Anforderungen an die Stabilität, den Frequenzgang und die Gruppenlaufzeit des geschlossenen Regelkreises für jeweils eine eingestellte mittlere Sendeleistung erfüllt. Das heißt, eine Korrekturverstärkung braucht bei einem mäßigen Modulationsindex und einer mäßigen Linearität nicht im Takt der Amplitudenmodulation mitgeführt zu werden. Dieses Verfahren ist daher auch allgemein in anderen Regelkreisen für eine Amplitudenmodulation unabhängig von der erfindungsgemäßen Idee der Dämpfung des rückgekoppelten Signals anwendbar. Es handelt sich daher um eine eigenständige erfinderische Idee.

Die Linearisierung kann außer mittels der bereits genannten Änderung einer Korrekturverstärkung im Amplitudenmodulationssignal allgemein mittels einer Einstellung von Parametern eines Verstärkers und/oder im Regelkreis des Amplitudenmodulationssignals, beispielsweise in Abhängigkeit von der eingestellten mittleren Sendeleistung, erfolgen. Die Parameter können hierbei die besagte Verstärkung, aber z. B. auch eine Frequenzcharakteristik umfassen. Erforderlich sind lediglich geeignete Mittel bzw. Bauelemente, beispielsweise ein Verstärker oder ein Regler mit entsprechend einstellbaren Parametern.

Vorzugsweise wird ein sogenannter PID-Regler verwendet. Ein PID-Regler hat drei parallel geschaltete Anteile, nämlich einen proportionalen für die Stabilität, einen integrierenden zur Vermeidung eines statischen Regelfehlers und einen differenzierenden, um eine hohe Geschwindigkeit zu erreichen. Eine solche Kombination hat sich zur Korrekturregelung im Amplitudenzweig bereits bewährt. Bei Verwendung eines PID-Reglers kann die Verstärkungsanpassung im Vorwärtszweig für jeden der drei Anteile auch unterschiedlich sein, d. h. es wird in Abhängigkeit von dem eingestellten Sendeleistungspegel exakt eine passende Frequenzcharakteristik mit den drei Regelzweigen des PID-Reglers eingestellt.

Im Prinzip können diese Bauteile zur Korrektur an beliebiger Stelle im Regelkreis angeordnet sein. Sofern aber das erfindungsgemäße Verfahren genutzt wird, dass der Sendeleistungspegel durch eine einstellbare Dämpfung und/oder Verstärkung in dem rückgeführten Signal eingestellt wird, so dass das Soll-Signal unabhängig vom Sendeleistungspegel ist, so ist eine Einstellung der Korrekturverstärkung bzw. der Korrekturparameter zwischen dem Vergleicher und der Endstufe zweckmäßig, um die Signale im Vorwärtszweig entsprechend der Sendeleistungsstufe zu skalieren. Die Korrekturverstärkung im Vorwärtszweig hat den Vorteil, dass die Schleifenverstärkung konstant gehalten wird. Wenn die Dämpfung in der Rückführung also beispielsweise um 1 dB erhöht wird, so ist beim linearen Verhalten eine um ein 1 dB höhere Verstärkung im Vorwärtszweig angebracht.

Vorzugsweise wird bei der Regelung in einem logarithmischen Maßstab gearbeitet. Das heißt, der Ist-Wert und der Soll-Wert in der Regelschleife werden in einem logarithmischen Maßstab verglichen. Bei einem Übergang auf den logarithmischen Maßstab sinken die Anforderungen an die Dynamik im Amplitudenrückkopplungszweig noch weiter. Für den Übergang auf den logarithmischen Maßstab, d. h. zur Umsetzung eines Signals in ein logarithmisches Signal, bietet sich ein logarithmischer Verstärker an. Darüber hinaus existieren bereits Hüllkurvendetektoren im Handel, die gleichzeitig die Amplitude logarithmieren und ein begrenztes Signal bereitstellen, welches für eine Phasenrückkopplungsschleife geeignet wäre.

Da eine Multiplikation im linearen Maßstab einer Addition im logarithmischen Maßstab entspricht, kann der logarithmische Messwert bzw. das Ergebnis des Vergleichs im logarithmischen Maßstab innerhalb der Regelschleife durch Addition einer Konstanten mit dem eingestellten Sendeleistungspegel verrechnet werden. Eine aufwändigere Multiplikation ist dann nicht erforderlich.

Zu berücksichtigen ist dabei allerdings, dass die Differenz zwischen dem Logarithmus des Ist-Werts $\ln(x+\Delta x)$ und dem Logarithmus des Soll-Werts $\ln(x)$ zwar das richtige Vorzeichen hat, aber nicht proportional zum Regelfehler $\Delta x$ ist. Wenn für kleine $\Delta x$ ungefähre Proportionalität gelten soll, kann die Differenz mit dem Soll-Wert x multipliziert werden. Es gilt dann:

$$x\left[\ln\left(x+\Delta x\right)-\ln\left(x\right)\right]\approx x\left[\left(\ln\left(x\right)+\Delta x\cdot 1/x\right)-\ln\left(x\right)\right]=\Delta x$$

Je nach Modulationsindex ist es bei einer logarithmischen Regelung auch möglich, die Verstärkung im Vorwärtszweig der Regelschleife auf Basis einer Art Mittelwert von x, beispielsweise des Werts des gewünschten Sendeleistungspegels, anstatt auf der Basis des Momentanwerts *x* des Werts der Amplitude, nachzuführen.

Wenn die Regelung der Amplitude mit einer Steuerung der Amplitude kombiniert wird, beispielsweise die Versorgungsspannung des Sendeverstärkers sich aus einem gesteuerten Anteil und einem geregelten Anteil zusammensetzt, und wenn bei der Regelung die mittlere Sendeleistung durch eine variable Dämpfung in der Rückführung eingestellt wird, kann es je nach Ausführung der Steuerung erforderlich sein, das Steuersignal entsprechend der mittleren Sendeleistung zu skalieren. Diese Aufgabe wird beispielsweise dadurch gelöst, dass die Abtastwerte für die Amplitude, die nur eine Information über die Modulation, aber noch nicht über die Sendeleistungsstufe enthalten, bei der Steuerung mit einem der Sendeleistungsstufe entsprechenden Wert multipliziert werden.

Wenn das Sendesignal in ein Signal mit der Amplitudeninformation und ein Signal mit der Winkelinformation getrennt wird, müssen diese Teilsignale zeitsynchronisiert wieder kombiniert werden, damit sich das ursprüngliche Signal ergibt. Bei einer getrennten Verarbeitung der Teilsignale ergibt sich im Allgemeinen für jedes der Teilsignale eine andere Übertragungsfunktion mit einer anderen Gruppenlaufzeit. In einer Regelschleife mit schwankender Schleifenverstärkung ergibt sich im Allgemeinen eine je nach Schleifenverstärkung andere Gruppenlaufzeit. Wenn die Schleifenverstärkung des Amplitudenregelkreises eine Funktion der Sendeleistungsstufe ist und somit die Gruppenlaufzeit der Amplitudeninformation von der Sendeleistungsstufe abhängt, werden bei einer bevorzugten Lösung Mittel vorgesehen, um die Schwankungen in der Gruppenlaufzeit auszugleichen. Dadurch wird erreicht, dass die Amplituden- und die Phaseninformation bei ihrer Kombination zeitlich zueinander passen. Besonders vorteilhaft ist ein digitaler Ausgleich von Gruppenlaufzeitunterschieden, bei dem ggfls. in Abhängigkeit der Sendeleistungsstufe bereits im Digitalteil ein geeigneter Zeitversatz der Teilsignale eingestellt wird.

Die Erfindung wird im Folgenden unter Hinweis auf die beigefügten Zeichnungen anhand von Ausführungsbeispielen näher erläutert. Es wird ausdrücklich darauf hingewiesen, dass die einzelnen Merkmale nicht nur in den beschriebenen Kombinationen, sondern auch einzeln oder in anderen Kombinationen erfindungswesentlich sein können. Insbesondere können alle nur verfahrensmäßig beschriebenen Merkmale auch bezüglich einer entsprechenden Schaltung erfindungswesentlich sein und umgekehrt. In den Figuren werden in den verschiedenen Ausführungsbeispielen verwendete gleichartige Bauteile mit denselben Bezugsziffern bezeichnet. Es stellen dar:

Figur 1 ein schematisches Blockschaltbild für eine erfindungsgemäße Amplitudenmodulationssignal-Regelschleife gemäß einem ersten Ausführungsbeispiel.

Figur 2 ein schematisches Blockschaltbild für eine erfindungsgemäße Amplitudenmodulaticnssignal-Regelschleife gemäß einem zweiten Ausführungsbeispiel.

Figur 3 ein schematisches Blockschaltbild für eine erfindungsgemäße Sendeschaltung.

Figur 4 eine Darstellung der Hochfrequenzausgangsspannung (umgerechnet auf 50 Ohm) in Abhängigkeit der Versorgungsspannung bei einer in der Sättigung betriebenen dreistufigen 6 Volt-Sendeendstufe im Bereich 900 MHz.

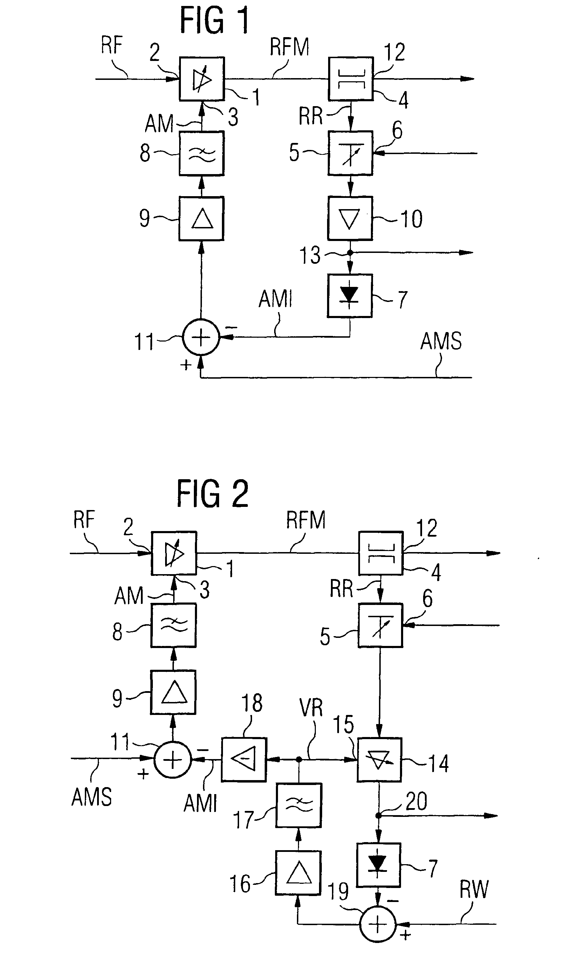

Bei dem Ausführungsbeispiel gemäß Figur 1 handelt es sich um eine erfindungsgemäß aufgebaute Regelschleife innerhalb einer Sendeschaltung zur Erzeugung eines amplituden- und winkelmodulierten Sendesignals. Hierbei wird ein rein winkelmoduliertes Eingangssignal RF auf einen Signaleingang 2 eines Sendeverstärkers 1 gegeben. Es kann sich prinzipiell aber auch um ein unmoduliertes Eingangssignal handeln. Auf einen zweiten Eingang 3 des Sendeverstärkers 1 wird ein amplitudenmoduliertes Signal aufgegeben. Bei diesem zweiten Eingang 3 handelt es sich um den Versorgungsspannungseingang, das heißt, es wird über die Versorgungsspannung die Amplitude auf das winkelmodulierte Signal RF aufmoduliert, so dass am Ausgang des Sendeverstärkers 1 das gewünschte amplituden- und winkelmodulierte Sendesignal RFM vorliegt.

Das Sendesignal RFM wird zunächst zu einem Richtkoppler 4 geleitet und von dort über einen Ausgang 12 zu einer Antenne weitergeleitet. Der Richtkoppler koppelt einen Teil des Sendesignals RFM als Rückkopplungssignal RR aus. Der Richtkoppler erfasst hierbei im Wesentlichen nur die vom Sendeverstärker 1 zur Antenne laufende Welle, und die von der Antenne ggf. rückreflektierten Anteile werden stark unterdrückt. Das rückgekoppelte Signal RR enthält die Ist-Werte der aktuellen Amplitude und des aktuellen Winkels und kann daher in einer Regelschleife genutzt werden, um sowohl das winkelmodulierte Eingangssignal als auch das amplitudenmodulierte Eingangssignal zu regeln.

Hierzu wird, wie in der Figur dargestellt, das rückgekoppelte Signal RR zunächst in einem einstellbaren Abschwächer 5 auf einen bestimmten Wert abgeschwächt. Dieser Abschwächer 5 ist über den Eingang 6 steuerbar. Weiterhin wird das Signal RR in einem Verstärker 10, welcher optional ist, um einen festgelegten Wert verstärkt und anschließend einem Hüllkurvendetektor 7 zugeführt, welcher die Amplitudeninformation aus dem rückgekoppelten Anteil RR des Sendesignals RFM extrahiert.

Vor diesem Hüllkurvendetektor 7 wird an einem Abzweig 13 das Signal RR abgeführt, um in einer Phasenregelschleife als Ist-Wert zum Regeln des winkelmodulierten Signals zu dienen. Hinter dem Hüllkurvendetektor 7 liegt der Ist-Wert AMI der aktuellen Amplitude des amplitudenmodulierten Signals vor, der in einem Vergleicher 11, hier ein Subtraktionsglied 11, mit dem Soll-Signal AMS für die Amplitudenmodulation verglichen wird. Die Differenz dieses Soll-Werts AMS und des Ist-Werts AMI wird in einem Regelverstärker 9 verstärkt und anschließend über einen die Regelcharakteristik bestimmenden Filter 8 geführt und steht dann als Amplitudenmodulationssignal AM, d. h. als Stellgröße für den Versorgungsspannungseingang 3 des Sendeverstärkers 1, zur Verfügung.

Die Kette aus Richtkoppler 4, einstellbarem Dämpfungsglied 5 und Verstärker 10 ist so dimensioniert, dass die Gesamtdämpfung des rückgekoppelten Signalanteils RR gegenüber dem Sendesignal RFM genau einer gewünschten mittleren Sendeleistung entspricht. Das heißt, das Signal RR in der Rückkopplung wird entsprechend der gewünschten Sendeleistung gedämpft (bzw. verstärkt, sofern die Dämpfung durch den Richtkoppler 4 zu hoch ist), noch bevor es den Hüllkurvendetektor 7 durchläuft. Insgesamt verbleibt hinter dem Dämpfungsglied 5 die modulationsbedingte Amplitudenmodulation mit einer konstanten mittleren Leistung.

Anstelle des dargestellten Aufbaus von Richtkoppler 4, nachfolgendem Dämpfungsglied 5 und nachfolgendem Verstärker 10 ist selbstverständlich auch eine beliebige andere Anordnung und Kombination von Dämpfungs- und/oder verstärkenden Elementen möglich. Die Anordnung des einstellbaren Dämpfungsgliedes 5 vor dem konstanten Verstärker 10 hat den Vorteil, dass am Verstärker 10 ein in der Höhe konstantes Eingangssignal anliegt und daher der Verstärker 10 bezüglich seiner Linearität auf diese Eingangsspannung optimiert sein kann.

Über das einstellbare Dämpfungsglied lässt sich die mittlere Sendeleistung einstellen. Wird eine höhere/niedrigere mittlere Sendeleistung gewünscht, so wird entsprechend über den Eingang 6 durch eine Sendepegelsteuerung (nicht dargestellt) eine höhere/niedrigere Dämpfung eingestellt. Dadurch wird automatisch innerhalb der Regelschleife der Sendeleistungspegel solange erhöht/verringert, bis Soll- und Ist-Signal am Vergleicher 11 wieder übereinstimmen.

Der Vorteil dieser Einstellung der mittleren Sendeleistung über eine einstellbare Dämpfung im rückgekoppelten Signal besteht darin, dass für alle der einstellbaren Dämpfung nachfolgenden Komponenten im Regelkreis, insbesondere für den Hüllkurvendetektor 7 und den Vergleicher 11 erheblich geringere Dynamikanforderungen bestehen. Außerdem muss auch das Soll-Signal AMS für die Amplitude nicht im gesamten Dynamikumfang vorhanden sein. Das heißt, es werden beim Vergleich zwischen Soll- und Ist-Werten keine sendungsleistungspegelabhängigen Soll-Werte benötigt. Bei einer Modulation im EDGE-Standard kann beispielsweise eine Dämpfung um 37 dB für eine mittlere Sendeleistung von 27 dBm (= 0,5 W) und um 10 dB für eine gewünschte mittlere Sendeleistung von 0 dBm (= 1 mW) erfolgen. Dadurch wird die Dynamik von den ansonsten insgesamt 44 dB auf die durch die Amplitudenmodulation vorgegebenen 17 dB für alle der Dämpfung nachfolgenden Schaltungsteile innerhalb des Rückkopplungszweiges reduziert.

Da sich die Abzweigung 13 zur Rückführung des Signals für den Phasenregelkreis ebenfalls hinter den Dämpfungsgliedern 4, 5, 10 befindet, werden auch innerhalb einer solchen Schleife die Anforderungen an die Baugruppen wie Mischer, Begrenzer und Phasendetektor reduziert.

Figur 2 zeigt ein weiteres vorteilhaftes Ausführungsbeispiel für solche Modulationsarten, bei denen die Amplitude nicht Null wird. Dieses Beispiel weist einen zusätzlichen Regelkreis auf, der von einem regelbaren Verstärker 14, welcher in dem eingeschränkten Dynamikbereich eine lineare Regelkennlinie aufweist, einem Phasendetektor 7, einem Vergleicher 19 und einem nachfolgenden Regelverstärker 16 mit anschließendem Tiefpass 17 gebildet wird.

Innerhalb dieses Regelkreises (7, 14, 15, 16, 17, 19) wird das amplituden- und winkelmodulierte rückgekoppelte Signal RR auf einen konstanten Spannungswert geregelt. Dieser konstante Spannungswert wird durch einen am Vergleicher 19 als Soll-Wert anliegenden Referenzwert RW vorgegeben. Der Ist-Wert wird am Ausgang des regelbaren Verstärkers 14 über den Hüllkurvendetektor 7 ermittelt und ebenfalls dem Vergleicher 19 zugeführt. Die Differenz wird durch den Regelverstärker 16 verstärkt und durch den nachfolgenden Filter 17 (z. B. Integrator) geführt. Das am Ausgang des Filters 17 anliegende Signal VR ist die Regelspannung, die an den Regelspannungseingang 15 des regelbaren Verstärkers 14 angelegt wird. Diese Regelspannung VR ist negativ proportional zum Logarithmus der Amplitude des rückgekoppelten Anteils RR des Sendesignals RFM und kann folglich als Ist-Wert innerhalb der Regelschleife für den Sendeverstärker 1 verwendet werden. Sie wird daher außerdem über einen Inverter 18 als Ist-Wert AMI einem Vergleicher 11 zugeführt, und dort wird die Differenz zu dem Soll-Wert AMS ermittelt.

Durch diese zusätzliche Regelschleife mit dem regelbaren Verstärker 14 werden die Anforderungen an den Hüllkurvendetektor 7 noch weiter reduziert, da dieser lediglich die Abweichungen von dem konstanten Spannungswert detektieren muss. Außerdem steht für eine Phasenregelschleife am Ausgang 20 ein Signal zur Verfügung, das überhaupt nicht mehr amplitudenmoduliert ist, sondern die reine Phaseninformation enthält.

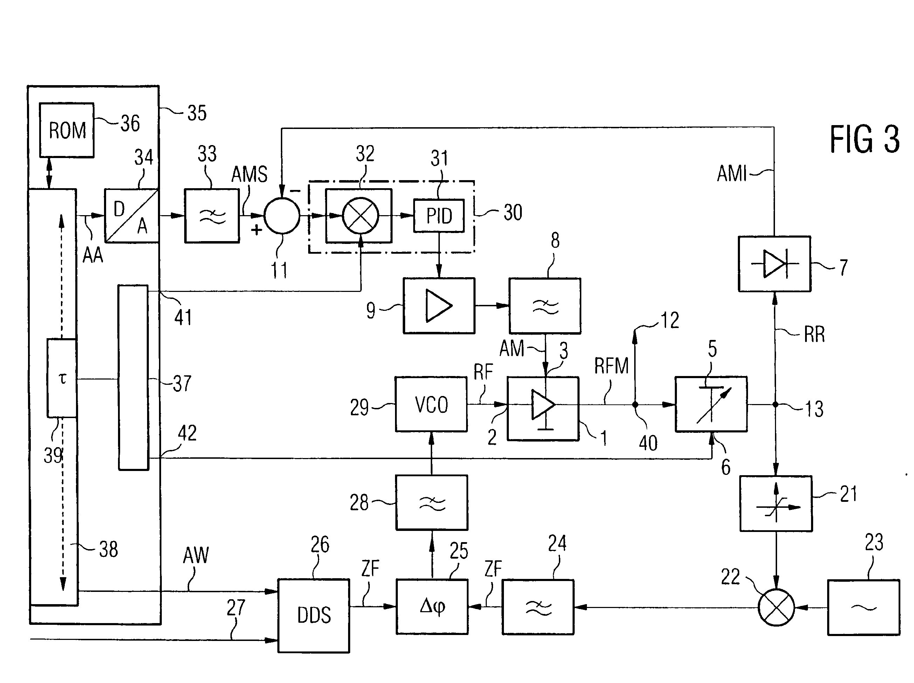

Figur 3 zeigt ein Ausführungsbeispiel für eine Sendeschaltung, welche das erfindungsgemäße Verfahren innerhalb eines Regelkreises für das Amplitudenmodulationssignal nutzt. Diese Schaltung weist zunächst einen Digitalteil 35 auf, der hier als ein Block dargestellt ist. Bei diesem Digitalteil 35 kann es sich aber auch um mehrere geeignet verschaltete Teile handeln. Insbesondere kann dieser Digitalteil 35 auch einen im Mobilfunk üblichen Digitalen Signalprozessor (DSP) enthalten, welcher die zu übersendenden Informationen, das heißt die Sprach- und sonstigen Daten, in die digitalen codierten Werte umsetzt.

In diesem Digitalteil der Sendeschaltung sind die Sendekurvenverläufe zu jeder möglichen Symbolfolge, die übersendet werden muss, bereits in Digitalwerte zerlegt in Amplituden- und Momentanfrequenzverläufe, in einem ROM 36 gespeichert. In Abhängigkeit von dem jeweils auszugebenden und, soweit eine Intersymbolinterferenz vorliegt, auch von den vorangehenden und nachfolgenden Symbolen, wird ein aus Abtastwerten für eine Symboldauer bestehender Kurvenverlauf aus diesem ROM (36) ausgewählt. Jeder Sendekurvenverlauf ist dabei in Form von einigen Abtastwerten AA für die Amplitude und einigen Abtastwerten AW für die Abweichung der Momentanfrequenz von der Trägerfrequenz gespeichert. Dabei bilden je ein Abtastwert AA für die Amplitude und ein Abtastwert AW für die Momentanfrequenz zusammen ein Paar. Diese Abtastwertpaare AA, AW werden während der Dauer eines zu übersendenden Symbols an die Schaltungsteile zur Einstellung der Amplitude und zur Einstellung der Momentanfrequenz ausgegeben.

Das frequenzmodulierte Signal wird hierbei mittels eines Frequenzsynthesizers, hier eines Direct Digital Synthesizers (DDS) 26, erzeugt, welchem zum einen über den Eingang 27 eine Mittenfrequenz, d. h. die Trägerfrequenz des Signals, und zum anderen vom Digitalteil 35 ein Abtastwert AW für die Abweichung der Momentanfrequenz von der Trägerfrequenz vorgegeben wird. Dieser DDS 26 erzeugt eine frequenzmodulierte Schwingung ZF in einer zwischenfrequenten Lage. Das frequenzmodulierte Signal ZF wird einem Phasenkomparator 25 zugeführt, der zusammen mit einem Schleifenfilter 28, einem VCO (Voltage Controlled Oscillator) 29, einem Lokaloszillator 23, einem Mischer 22 und einem Tiefpass 24 eine Phasenregelschleife, hier eine sog. Offset-PLL (Phase-Locked-Loop) bildet.

Um eine durch die AM/PM-Konversion bedingte variable Phasendrehung des hinter dem VCO 29 angeordneten Sendeverstärkers 1 zu kompensieren, wird nicht das Eingangssignal des Sendeverstärkers 1, sondern das Ausgangssignal geregelt.

Am Ausgang des Sendeverstärkers 1 hat das rückzuführende Signal, welches zum überwiegenden Teil an der Abzweigung 40 über den Ausgang 12 zu einer Antenne geleitet wird, eine stark schwankende Amplitude. Dies hat Nachteile für die Rückkopplung. Zum einen wird eine hohe Dynamik vom Mischer 22 der Offset-PLL und vom Phasenkomparator 25 gefordert. Zum anderen ergeben sich aussteuerungsabhängige Phasendrehungen, welche wiederum eine unerwünschte AM/PM-Konversion hervorrufen würden. Deshalb wird der Teil RR des Sendesignals, welcher für die Rückkopplung am Punkt 40 abgezweigt wird, zunächst einem steuerbaren Dämpfungsglied 5 zugeführt.

In diesem Dämpfungsglied 5 wird das rückgekoppelte Signal RR von jenem Dynamikanteil befreit, welcher durch eine Sendepegelsteuerung 37 aufgebracht wird. Anschließend wird das ausgehende Signal des Dämpfungsgliedes 5 an einem Abzweigpunkt 13 geteilt und zum einen zur Regelung eines Amplitudenmodulationssignals zurückgeführt und zum anderen innerhalb der Offset-PLL einem Begrenzer 21 zugeführt. Dieser Begrenzer 21 entfernt die verbleibende (modulationsbedingte) Amplitudenmodulation, so dass dem Mischer 22 ein Signal mit möglichst konstanter oder zumindest nach oben hin begrenzter Amplitude zugeführt wird. Mit einem Lokaloszillator 23, welcher auch als Hauptoszillator die Taktfrequenz für die DDS 26 liefern kann, wird der rückgekoppelte Anteil RR des Sendesignals wieder auf die Zwischenfrequenz umgesetzt. Es erfolgt dann in dem Tief- oder Bandpass 24 eine Befreiung von unerwünschten Mischprodukten und ein Vergleich mit der Referenzschwingung aus der DDS 26 im Phasenvergleicher 25.

Von einer Ausgabeeinheit 38, welche die Abtastwerte AA, AW aus dem ROM 36 auswählt, wird der zu dem Abtastwert AW für den Winkel gehörige Abtastwert AA der Amplitude über einen Digital-Analog-Wandler 34 ausgegeben. Die Ausgabe erfolgt hier derart zeitversetzt zueinander, dass am Sendeverstärker 1 die Werte zeitlich wieder zueinander passend zusammengeführt werden. Dieser Zeitversatz kann über eine Steuereinheit 39, welche mit der Sendepegelsteuerung 37 verbunden ist, in Abhängigkeit vom Sendepegel oder sogar von der Aussteuerung des Sendeverstärkers 1 erfolgen.

Die am Digital-Analog-Wandler 34 ausgegebenen Amplituden-Soll-Werte werden in einem Tiefpass 33 geglättet. Der Ausgangswert enthält nur die modulationsbedingte Dynamik, der Sendeleistungspegel wird über einen weiteren Ausgang 42 des Digitalteils 35 und den Eingang 6 des Abschwächers 5 getrennt eingestellt. Bei dem vorliegenden Ausführungsbeispiel erfolgt die Abschwächung stufenweise, d. h. es wird einfach der Abschwächer 5 von einer Abschwächungsstufe auf eine andere diskrete Abschwächungsstufe umgestellt. Dies führt innerhalb des Amplitudenregelkreises automatisch zu einer entsprechenden Einstellung der Gesamtsendeleistung am Ausgang des Sendeverstärkers 1, wie dies bei dem Ausführungsbeispiel gemäß Figur 1 genauer erläutert wurde. Das am Ausgang des Tiefpasses 33 anliegende Amplituden-Soll-Signal AMS wird mit einem Amplituden-Ist-Signal AMI verglichen, das über einen am Abzweig 13 angeschlossenen Hüllkurvendetektor 7 aus dem rückgekoppelten Signalanteil RR des Sendesignals RFM gewonnen wird. Der Vergleich findet in einem Vergleicher 11 statt.

Das Differenzsignal wird einer Regeleinheit 30 zugeführt, die hier aus einem PID-Regler 31 und einem vorgeschalteten Multiplikatorglied 32 besteht. Im Multiplikatorglied 32 wird das vom Vergleicher 11 kommende Differenzsignal mit einer vom Sendeleistungspegel abhängigen Konstanten multipliziert. Dieser Wert wird ebenfalls von der Sendepegelsteuerung 37 über einen Ausgang 41 des Digitalteils 35 ausgegeben. Durch diese Multiplikation werden die aussteuerungsabhängigen unterschiedlichen differenziellen Schleifenverstärkungen im Regelkreis, welche vom nichtlinearen Verhalten des Sendeverstärkers 1 und von der vom Sendeleistungspegel abhängigen Dämpfung in der Rückführung herrühren, so kompensiert, dass die geschlossene Regelschleife einerseits stets stabil bleibt und andererseits in ihrer Übertragungsfunktion nicht zu schmalbandig wird. Ferner werden dadurch die Schwankungen in der Gruppenlaufzeit des geschlossenen Regelkreises reduziert.

Ein innerhalb der Regeleinheit 30 angeordneter PID-Regler 31 sorgt außerdem für eine Stabilität und Schnelligkeit in der Regelung und verhindert bleibende Regelfehler. Nachfolgend zum PID-Regler findet sich ein Class S-Verstärker 9, d. h. ein Schaltverstärker, welcher das Signal mit hohem Wirkungsgrad in eine pulsweitenmodulierte Schwingung umsetzt, deren Schaltfrequenz und Störlinien von einem nachfolgenden Tiefpass 8 unterdrückt werden.

Der Sendeverstärker 1 wird eingangsseitig, d. h. bezüglich des winkelmodulierten Signaleingangs RF in die Sättigung gefahren und nur über die Versorgungsspannung am Eingang 3 mittels des Amplitudenmodulationssignals AM in der Verstärkung moduliert.

Wenn eine höhere mittlere Sendeleistung gewünscht wird, wird von der Sendepegelsteuerung 37 eine höhere Dämpfung am Dämpfungsglied 5 eingestellt. Gleichzeitig wird die Schleifverstärkung in der Amplitudenregelung erhöht. Die Regelschleife erhöht den Sendepegel dann solange, bis die Hüllkurve des jetzt stärker gedämpften Anteils RR des Sendesignals RFM wieder den Soll-Wert am Vergleicher 11 erreicht. Soll dagegen ein schwächerer Sendeleistungspegel eingestellt werden, so werden die Dämpfung des einstellbaren Dämpfungsgliedes 5 und die Schleifenverstärkung in der Amplitudenregelung verringert. Am Vergleicher 11 ergibt sich eine zu hohe Ist-Amplitude, bis der Regelkreis den Sendeleistungspegel abgesenkt hat. Gleichzeitig werden von der Sendepegelsteuerung 37 die Werte am Multiplikatorglied 32 korrigiert, um im Bereich des neuen Sendeleistungspegels eine Linearisierung der Amplitudenregelschleife zu erreichen, und es wird der Zeitversatz bei der Ausgabe der Abtastwerte AA, AW für die Amplitude und für den Winkel eingestellt.

Die erfindungsgemäße variable Dämpfung erspart erheblichen Aufwand für die Linearisierung von Detektorkennlinien oder für die sonstige Verarbeitung über einen sehr großen Signalamplitudenbereich. Außerdem hat sie den Vorteil, dass nur ein Sollwertefeld für die Amplitudenmodulation für nur eine mittlere Leistung berechnet und gespeichert werden muss und eine Skalierung in einen großen Bereich nicht notwendig ist.

Liste der verwendeten Abkürzungen:

| | |
|---|---|
| PLL | Phase-Locked-Loop |
| DDS | Direct Digital Synthesis |
| DSP | Digitaler Signalprozessor |
| EER | Envelope Elimination and Restoration |
| PID | proportional, integrierend und differenzierend wirkender Regler |
| VCO | Voltage Controlled Oscillator |
| EDGE | Enhanced Data Rates for GSM Evolution |
| CDMA | Code Division Multiple Access |

Bezugszeichenliste

| | |
|---|---|
| 1 | Sendeverstärker |
| 2 | Signaleingang |
| 3 | Versorgungsspannungseingang |
| 4 | Richtkoppler |
| 5 | Abschwächer |
| 6 | Eingang |
| 7 | Hüllkurvendetektor |
| 8 | Filter |
| 9 | Verstärker |
| 10 | Verstärker |
| 11 | Vergleicher |
| 12 | Ausgang |
| 13 | Abzweigung |
| 14 | regelbarer Verstärker |
| 15 | Regelspannungseingang |
| 16 | Verstärker |
| 17 | Filter |
| 18 | Inverter |
| 19 | Vergleicher |
| 20 | Ausgang |
| 21 | Begrenzer |
| 22 | Mischer |

| | |
|---|---|
| 23 | Lokaloszillator |
| 24 | Tiefpassfilter |
| 25 | Phasenkomparator |
| 26 | digitale Syntheseschaltung/DDS |
| 27 | Eingang |
| 28 | Schleifenfilter |
| 29 | VCO |
| 30 | Regeleinheit |
| 31 | PID-Regler |
| 32 | Multiplikatorglied |
| 33 | Tiefpass |
| 34 | Digital-Analog-Wandler |
| 35 | Digitalteil |
| 36 | ROM |
| 37 | Sendepegelsteuerung |
| 38 | Signal-Ausgabeeinheit |
| 39 | Steuereinheit |
| 40 | Abzweigpunkt |
| 41 | Ausgang |
| 42 | Ausgang |
| AM | Amplitudenmodulationssignal |
| AA | Amplituden-Abtastwert |
| AW | Winkel-Abtastwert |
| RF | winkelmoduliertes Signal |
| RW | Referenzwert |
| RR | rückgekoppelter Signalanteil |
| VR | Regelspannung |
| ZF | Zwischenfrequenz |
| RFM | Sendesignal |
| AMS | Amplituden-Soll-Signal |
| AMI | Amplituden-Ist-Signal |

**Patentansprüche**

1. Verfahren zur Erzeugung eines amplitudenmodulierten Sendesignals (RFM) mit einer einstellbaren mittleren Sendeleistung, bei dem ein Amplitudenmodulationssignal (AM) an einen Eingang (3) eines Sendeverstärkers (1) angelegt wird und bei dem das Amplitudenmodulationssignal (AM) unter Nutzung eines rückgekoppelten Anteils (RR) des Sendesignals (RFM) in einem Regelkreis für das Amplitudenmodulationssignal abgeleitet wird, wobei der rückgekoppelte Anteil (RR) des Sendesignals (RFM) entsprechend der gewünschten mittleren Sendeleistung gedämpft zur Regelung genutzt wird,
und wobei der Regelkreis für das Amplitudenmodulationssignal einen Rückführungszweig (40, 5, 13, 7), in den der rückgekoppelte Anteil (RR) des Sendesignals (RFM) eingeht, und einen Vorwärtszweig (30, 9, 8, 3, 1), in dem das an den Sendeverstärker (1) anzulegende Amplitudenmodulationssignal (AM) abgeleitet wird, aufweist,
**dadurch gekennzeichnet,**
**dass** im Vorwärtszweig des Regelkreises eine Verstärkung und/oder eine Frequenzcharakteristik (30) in Abhängigkeit der gewünschten mittleren Sendeleistung angepasst wird.

2. Verfahren nach Anspruch 1, **dadurch gekennzeichnet, dass** die gewünschte Dämpfung mittels eines variablen Dämpfungsglieds (5) eingestellt wird.

3. Verfahren nach Anspruch 1, **dadurch gekennzeichnet, dass** die gewünschte Dämpfung mittels einer Kombinationen von dämpfenden und verstärkenden Bauelementen (5,10), von denen zumindest eines einstellbar ist, eingestellt wird.

4. Verfahren nach einem der Ansprüche 1 bis 3, **dadurch gekennzeichnet, dass** die Dämpfung stufenweise eingestellt wird.

**5.** Verfahren nach einem der Ansprüche 1 bis 4, **dadurch gekennzeichnet, dass** mittels des Amplitudenmodulationssignals eine Feineinstellung der mittleren Sendeleistung erfolgt.

**6.** Verfahren nach Anspruch 5, **dadurch gekennzeichnet, dass** die Feineinstellung durch eine Skalierung von Abtastwerten für die Amplitude erfolgt.

**7.** Verfahren nach einem der Ansprüche 1 bis 6, **dadurch gekennzeichnet, dass** die Dämpfung geregelt wird.

**8.** Verfahren nach einem der Ansprüche 1 bis 7, **dadurch gekennzeichnet, dass** an einen ersten Eingang (2) des Sendeverstärkers (1) ein winkelmoduliertes Eingangssignal (RF) angelegt wird und das Amplitudenmodulationssignal (AM) an einen zweiten Eingang (3) des Sendeverstärkers (1) angelegt wird, so dass die Amplitude zur Erzeugung eines amplituden- und winkelmodulierten Sendesignals (RFM) im Sendeverstärker (1) auf das winkelmodulierte Eingangssignal (RF) aufmoduliert wird.

**9.** Verfahren nach einem der Ansprüche 1 bis 8, **dadurch gekennzeichnet, dass** eine Dämpfung entsprechend der gewünschten Sendeleistung des rückgekoppelten Signals vor einer Bestimmung eines Maßes für die momentane Amplitude aus dem rückgekoppelten Signal (RR) und/oder vor einem Abzweig (13) für eine Rückkopplung eines eine Winkelinformation enthaltenden Anteils des Sendesignals zur Regelung des winkelmodulierten Eingangssignals (RF) erfolgt.

**10.** Verfahren nach Anspruch 1-9, **dadurch gekennzeichnet, dass** die Bestimmung eines Maßes für die Amplitude mittels eines Hüllkurvendetektors (7) erfolgt.

**11.** Verfahren nach Anspruch 8, **dadurch gekennzeichnet, dass** das entsprechend der mittleren Sendeleistung gedämpfte rückgekoppelte Signal einem regelbaren Verstärker (14) zugeführt wird, der die Amplitude des rückgekoppelten Signals auf einen Festwert (RW) regelt.

**12.** Verfahren nach Anspruch 11, **dadurch gekennzeichnet, dass** die Regelspannung (VR) des regelbaren Verstärkers (14) zur Ermittlung eines Ist-Werts in der Regelung für das Amplitudenmodulationssignal (AM) für den Sendeverstärker (1) genutzt wird und/oder das auf den Festwert rückgekoppelte Signal zur Regelung des winkelmodulierten Eingangssignals (RF) für den Sendeverstärker (1) genutzt wird.

**13.** Verfahren nach einem der Ansprüche 1 bis 12, **dadurch gekennzeichnet, dass** der rückgekoppelte Anteil (RR) des Sendesignals mit einem Richtkoppler (4) ausgekoppelt wird.

**14.** Verfahren nach einem der Ansprüche 1 bis 13, **dadurch gekennzeichnet, dass** eine nichtlineare Funktion des Regelkreises für das Amplitudenmodulationssignal (AM) jeweils in einem Bereich um eine mittlere oder momentane Sendeleistung linearisiert wird.

**15.** Verfahren nach Anspruch 14, **dadurch gekennzeichnet, dass** die bereichsweise Linearisierung mittels einer Einstellung von Parametern eines Verstärkers und/oder Reglers (30) im Regelkreis des Amplitudenmodulationssignals (AM) in Abhängigkeit von der eingestellten mittleren Sendeleistung erfolgt.

**16.** Verfahren nach Anspruch 15, **dadurch gekennzeichnet, dass** die Parameter die Verstärkung und/oder die Frequenzcharakteristik umfassen.

**17.** Verfahren nach einem der Ansprüche 1 bis 16, **dadurch gekennzeichnet, dass** der Vergleich eines Ist-Werts und eines Soll-Werts in der Regelschleife des Amplitudenmodulationssignals in einem logarithmischen Maßstab durchgeführt wird.

**18.** Verfahren nach Anspruch 17, **dadurch gekennzeichnet, dass** der Differenzwert zwischen Ist- und Sollwert zur Ansteuerung des Sendeverstärkers mit einem von der Sollsendeleistung oder der mittleren Soll-Sendeleistung abgeleiteten Wert multipliziert wird.

**19.** Sendeschaltung zur Erzeugung eines amplitudenmodulierten Sendesignals (RFM) mit einstellbarer mittlerer Sendeleistung, mit einem Sendeverstärker (1),
mit Mitteln (8, 9, 30, 33, 34) zur Erzeugung eines Amplitudenmodulationssignals (AM), welche derart aufgebaut und/oder angeordnet sind, dass das Amplitudenmodulationssignal (AM) an einem Eingang (3) des Sendeverstärkers (1) anliegt, und

mit einer Regelschleife zur Regelung des Amplitudenmodulationssignals (AM) mit Mitteln (4, 40) zur Rückkopplung eines Anteils (RR) des amplitudenmodulierten Sendesignals (RFM) für die Regelung, wobei die Regelschleife Mittel (5) aufweist, um den rückgekoppelten Anteil des Sendesignals entsprechend einer gewünschten mittleren Sendeleistung zu dämpfen, **dadurch gekennzeichnet,** **dass** die Mittel zur Erzeugung Mittel (30) zur Anpassung einer Verstärkung und/oder einer Frequenzcharakteristik (30) in Abhängigkeit der gewünschten mittleren Sendeleistung aufweisen.

20. Sendeschaltung nach Anspruch 19, **gekennzeichnet durch** ein variables Dämpfungsglied (5) oder eine Kombination von dämpfenden und verstärkenden Bauelementen (5, 10), von denen zumindest eines einstellbar ist.

21. Sendeschaltung nach Anspruch 19 oder 20, **gekennzeichnet durch** ein Auskoppelelement mit variabler Dämpfung zum Auskoppeln eines Anteils aus dem Sendesignal.

22. Sendeschaltung nach Anspruch 20 oder 21, **dadurch gekennzeichnet, dass** das Dämpfungsglied oder das einstellbare Bauelement oder das Auskoppelelement mehrere Einstellstufen aufweist.

23. Sendeschaltung nach einem der Ansprüche 19 bis 22, **gekennzeichnet durch** eine Dämpfungs-Regelschleife zur Regelung der Dämpfung des rückgekoppelten Signals.

24. Sendeschaltung nach einem der Ansprüche 19 bis 23, **gekennzeichnet durch** einen Richtkoppler (4) zum Auskoppeln des Anteils (RR) des Sendesignals (RFM) für die Regelung.

25. Sendeschaltung nach einem der Ansprüche 19 bis 24, **dadurch gekennzeichnet, dass** an einem ersten Eingang (2) des Sendeverstärkers (1) ein winkelmoduliertes Eingangssignal (RF) anliegt und das Amplitudenmodulationssignal (AM) an einen zweiten Eingang des Sendeverstärkers (1) anliegt, so dass die Amplitude zur Erzeugung eines amplituden- und winkelmodulierten Sendesignals im Sendeverstärker auf das winkelmodulierte Eingangssignal aufmoduliert wird.

26. Sendeschaltung nach einem der Ansprüche 19 bis 25, **gekennzeichnet durch** einen Hüllkurvendetektor (7) zur Ermittlung der Amplitude des rückgekoppelten Signals.

27. Sendeschaltung nach einem der Ansprüche 19 bis 25, **gekennzeichnet durch** eine zweite Regelschleife (7, 14, 15, 16, 17, 19) mit einem regelbaren Verstärker (14), der das rückgekoppelte gedämpfte Signal auf einen Festwert (RW) regelt.

28. Sendeschaltung nach einem der Ansprüche 19 bis 27, **gekennzeichnet durch** Mittel (30, 31, 32) zur Linearisierung einer nichtlinearen Funktion des Regelkreises für das Amplitudenmodulationssignal (AM) jeweils in einem Bereich um eine mittlere oder momentane Sendeleistung.

29. Sendeschaltung nach Anspruch 28, **dadurch gekennzeichnet, dass** die Mittel zur Linearisierung einen Verstärker und/oder Regler (30) mit einstellbaren Parametern umfassen.

30. Sendeschaltung nach Anspruch 29, **dadurch gekennzeichnet, dass** die Mittel zur Linearisierung einen PID-Regler (31) mit einstellbarer Verstärkung und/oder Frequenzcharakteristik umfassen.

31. Sendeschaltung nach einem der Ansprüche 28 bis 30, **dadurch gekennzeichnet, dass** die Mittel zur Anpassung (30) die Mittel zur Linearisierung (30, 31, 32) umfassen.

32. Sendeschaltung nach einem der Ansprüche 19 bis 31, **gekennzeichnet durch** Mittel zum Umsetzen eines Ist-Werts in der Regelschleife des Amplitudenmodulationssignals in einem logarithmischen Maßstab.

33. Sendeschaltung nach Anspruch 32, **gekennzeichnet durch** Mittel zur Multiplikation eines Differenzwerts zwischen logarithmischen Ist-Wert und einem logarithmischen Sollwert zur Ansteuerung des Sendeverstärkers mit einem von der Sollsendeleistung oder der mittleren Soll-Sendeleistung abgeleiteten Wert.

34. Kommunikationsendgerät mit einer Sendeschaltung gemäß einem der Ansprüche 19 bis 33.

**Claims**

1. Method for generating an amplitude-modulated transmission signal (RFM) with an adjustable mean transmission power, in which an amplitude modulation signal (AM) is applied to an input (3) of a transmission amplifier (1) and in which the amplitude modulation signal (AM) is derived in a control loop for the amplitude modulation signal by using a feedback component (RR) of the transmission signal (RFM), wherein the feedback component (RR) of the transmission signal (RFM) is used for the regulation attenuated in accordance with the required mean transmission power, and the control loop for the amplitude modulation signal exhibits a feedback branch (40, 5, 13, 7) which includes the feedback component (RR) of the transmission signal (RFM) and a forward branch (30, 9, 8, 3, 1) in which the amplitude modulation signal (AM) to be applied to the transmission amplifier (1) is derived, **characterized in that** a gain and/or a frequency characteristic (30) in the forward branch of the control loop is adapted in dependence on the required mean transmission power.

2. Method according to claim 1, **characterized in that** the required attenuation is adjusted by means of a variable attenuator (5).

3. Method according to claim 1, **characterized in that** the required attenuation is adjusted by means of a combination of attenuating and amplifying components (5, 10), of which at least one is adjustable.

4. Method according to one of claims 1 to 3, **characterized in that** the attenuation is adjusted step by step.

5. Method according to one of claims 1 to 4, **characterized in that** the mean transmission power is adjusted finely by means of the amplitude modulation signal.

6. Method according to claim 5, **characterized in that** the fine adjustment is effected by means of scaling samples for the amplitude.

7. Method according to one of claims 1 to 6, **characterized in that** the attenuation is regulated.

8. Method according to one of claims 1 to 7, **characterized in that** a phase-modulated input signal (RF) is applied to a first input (2) of the transmission amplifier (1) and the amplitude modulation signal (AM) is applied to a second input (3) of the transmission amplifier (1) so that the amplitude is modulated onto the phase-modulated input signal (RF) for generating an amplitude- and phase-modulated transmission signal (RFM) in the transmission amplifier (1).

9. Method according to one of claims 1 to 8, **characterized in that** attenuation according to the required transmission power of the feedback signal takes place before determination of a measure of the instantaneous amplitude from the feedback signal (RR) and/or in front of a tap (13) for a feedback of a component of the transmission signal, containing phase information, for regulating the phase-modulated input signal (RF).

10. Method according to claims 1-9, **characterized in that** the determination of a measure of the amplitude takes place by means of an envelope detector (7).

11. Method according to claim 8, **characterized in that** the feedback signal, attenuated in accordance with the mean transmission power, is supplied to a controllable amplifier (14) which regulates the amplitude of the feedback signal to a fixed value (RW).

12. Method according to claim 11, **characterized in that** the control voltage (VR) of the controllable amplifier (14) is used for determining an actual value in the regulation for the amplitude modulation signal (AM) for the transmission amplifier (1) and/or the signal fed back to the fixed value is used for regulating the phase-modulated input signal (RF) for the transmission amplifier (1).

13. Method according to one of claims 1 to 12, **characterized in that** the feedback component (RR) of the transmission signal is coupled out by means of a directional coupler (4).

14. Method according to one of claims 1 to 13, **characterized in that** a non-linear function of the control loop for the amplitude modulation signal (AM) is in each case linearized in an area around a mean or instantaneous transmission power.

**15.** Method according to claim 14, **characterized in that** the area-by-area linearization takes place by setting parameters of an amplifier and/or controller (30) in the control loop of the amplitude modulation signal (AM) as a function of the mean transmission power set.

**16.** Method according to claim 15, **characterized in that** the parameters comprise a gain and/or a frequency characteristic.

**17.** Method according to one of claims 1 to 16, **characterized in that** the comparison of an actual value and of a nominal value is performed in a logarithmic scale in the control loop of the amplitude modulation signal.

**18.** Method according to claim 17, **characterized in that** the difference value between actual and nominal value is multiplied by a value derived from the nominal transmission power or the mean nominal transmission power for driving the transmission amplifier.

**19.** Transmission circuit for generating an amplitude-modulated transmission signal (RFM) with adjustable mean transmission power, comprising a transmission amplifier (1), comprising means (8, 9, 30, 33, 34) for generating an amplitude modulation signal (AM) which are configured and/or arranged in such a manner that the amplitude modulation signal (AM) is present at an input (3) of the transmission amplifier (1), and comprising a control loop for regulating the amplitude modulation signal (AM) with means (4, 40) for feeding back a component (RR) of the amplitude-modulated transmission signal (RFM) for the regulation, wherein the control loop exhibits means (5) for attenuating the feedback component of the transmission signal in accordance with a required mean transmission power, **characterized in that** the means for generating exhibit means (30) for adapting a gain and/or a frequency characteristic (30) in dependence on the required mean transmission power.

**20.** Transmission circuit according to in claim 19, **characterized by** a variable attenuator (5) or a combination of attenuating and amplifying components (5, 10), at least one of which is adjustable.

**21.** Transmission circuit according to claim 19 or 20, **characterized by** an output coupling element with variable attenuation for coupling a component out of the transmission signal.

**22.** Transmission circuit according to claim 20 or 21, **characterized in that** the attenuator or the adjustable component or the output coupling element exhibits a number of adjustment steps.

**23.** Transmission circuit according to one of claims 19 to 22, **characterized by** an attenuation control loop for regulating the attenuation of the feedback signal.

**24.** Transmission circuit according to one of claims 19 to 23, **characterized by** a directional coupler (4) for coupling out the component (RR) of the transmission signal (RFM) for the regulation.

**25.** Transmission circuit according to one of claims 19 to 24, **characterized in that** a phase-modulated input signal (RF) is present at a first input (2) of the transmission amplifier (1) and the amplitude modulation signal (AM) is present at a second input of the transmission amplifier (1) so that the amplitude is modulated onto the phase-modulated input signal for generating an amplitude- and phase-modulated transmission signal in the transmission amplifier.

**26.** Transmission circuit according to one of claims 19 to 25, **characterized by** an envelope detector (7) for determining the amplitude of the signal fed back.

**27.** Transmission circuit according to one of claims 19 to 25, **characterized by** a second control loop (7, 14, 15, 16, 17, 19) with a controllable amplifier (14) which regulates the attenuated signal fed back to a fixed value (RW).

**28.** Transmission circuit according to one of claims 19 to 27, **characterized by** means (30, 31, 32) for linearizing a non-linear function of the control loop for the amplitude modulation signal (AM), in each case within an area around a mean or instantaneous transmission power.

**29.** Transmission circuit according to claim 28, **characterized in that** the means for linearization comprise an amplifier and/or controller (30) with adjustable parameters.

**30.** Transmission circuit according to claim 29, **characterized in that** the means for linearization comprise a PID-type controller (31) with adjustable gain and/or frequency characteristic.

**31.** Transmission circuit according to one of claims 28 to 30, **characterized in that** the means for adaptation (30) comprise the means for linearization (30, 31, 32).

**32.** Transmission circuit according to one of claims 19 to 31, **characterized by** means for converting an actual value in the control loop of the amplitude modulation signal into a logarithmic scale.

**33.** Transmission circuit according to claim 32, **characterized by** means for multiplying a difference value between the logarithmic actual value and a logarithmic nominal value for driving the transmission amplifier with a value derived from the nominal transmission power or the mean nominal transmission power.

**34.** Communication terminal with a transmission circuit as according to one of claims 19 to 33.

**Revendications**

**1.** Procédé pour générer un signal d'émission (RFM) modulé en amplitude avec une puissance d'émission moyenne réglable, dans lequel un signal de modulation d'amplitude (AM) est appliqué sur une entrée (3) d'un amplificateur d'émission (1) et dans lequel le signal de modulation d'amplitude (AM) est dérivé en utilisant une partie (RR) réinjectée du signal d'émission (RFM) dans un circuit de réglage pour le signal de modulation d'amplitude, la partie injectée (RR) du signal d'émission (RFM) étant utilisée pour le réglage de façon atténuée en fonction de la puissance d'émission moyenne souhaitée, et le circuit de réglage pour le signal de modulation d'amplitude présentant une branche de recyclage (40, 5, 13, 7), dans laquelle la partie réinjectée (RR) du signal d'émission (RFM) est intégrée, et une branche avant (30, 9, 8, 3, 1) dans laquelle le signal de modulation d'amplitude (AM) appliqué sur l'amplificateur d'émission (1) est dérivé, **caractérisé en ce que**,
dans la branche avant du circuit de réglage, une amplification et/ou une caractéristique de fréquence (30) est adaptée en fonction de la puissance d'émission moyenne souhaitée.

**2.** Procédé selon la revendication 1, **caractérisé en ce que** l'amortissement souhaité est réglé au moyen d'un élément d'atténuation variable (5).

**3.** Procédé selon la revendication 1, **caractérisé en ce que** l'atténuation souhaitée est réglée au moyen d'une combinaison de composants (5, 10) d'atténuation et d'amplification, dont au moins un est réglable.

**4.** Procédé selon l'une quelconque des revendications 1 à 3, **caractérisé en ce que** l'atténuation est réglée de façon progressive.

**5.** Procédé selon l'une quelconque des revendications 1 à 4, **caractérisé en ce qu'**un réglage fin de la puissance d'émission moyenne s'effectue au moyen du signal de modulation d'amplitude.

**6.** Procédé selon la revendication 5, **caractérisé en ce que** le réglage fin s'effectue par une graduation de valeurs de balayage pour l'amplitude.

**7.** Procédé selon l'une quelconque des revendications 1 à 6, **caractérisé en ce que** l'atténuation est réglée.

**8.** Procédé selon l'une quelconque des revendications 1 à 7, **caractérisé en ce que** sur une première entrée (2) de l'amplificateur d'émission (1) est appliqué un signal d'entrée (RF) modulé en angle et le signal de modulation d'amplitude (AM) est appliqué sur une seconde entrée (3) de l'amplificateur d'émission (1), de sorte que l'amplitude pour générer un signal d'émission (RFM) modulé en amplitude et en angle est modulé dans l'amplificateur d'émission (1) sur le signal d'entrée (RF) modulé en angle.

**9.** Procédé selon l'une quelconque des revendications 1 à 8, **caractérisé en ce qu'**une atténuation intervient en fonction de la puissance d'émission souhaitée du signal réinjecté avant une détermination d'un critère pour l'amplitude momentanée à partir du signal réinjecté (RR) et/ou avant une dérivation (13) pour une réinjection à une partie, contenant une information d'angle, du signal d'émission pour le réglage du signal d'entrée (RF) modulé en angle.

**10.** Procédé selon l'une des revendications 1 à 9, **caractérisé en ce que** la détermination d'un critère pour l'amplitude s'effectue au moyen d'un détecteur d'enveloppante (7).

**11.** Procédé selon la revendication 8, **caractérisé en ce que** le signal réinjecté, atténué en fonction de la puissance d'émission moyenne, est amené à un amplificateur (14) réglable qui règle l'amplitude du signal réinjecté sur une valeur fixe (RW).

**12.** Procédé selon la revendication 11, **caractérisé en ce que** la tension de réglage (VR) de l'amplificateur (14) réglable est utilisée pour déterminer une valeur réelle dans le réglage pour le signal de modulation d'amplitude (AM) pour l'amplificateur d'émission (1) et/ou le signal réinjecté sur la valeur fixe est utilisé pour le réglage du signal d'entrée (RF) modulé en angle pour l'amplificateur d'émission (1).

**13.** Procédé selon l'une quelconque des revendications 1 à 12, **caractérisé en ce que** la partie réinjectée (RR) du signal d'émission est dissociée avec un coupleur directif (4).

**14.** Procédé selon l'une quelconque des revendications 1 à 13, **caractérisé en ce qu'**une fonction non linéaire du circuit de réglage pour le signal de modulation d'amplitude (AM) est linéarisée à chaque fois dans une plage d'une puissance d'émission moyenne ou momentanée.

**15.** Procédé selon la revendication 14, **caractérisé en ce que** la linéarisation par zone s'effectue au moyen d'un réglage de paramètres d'un amplificateur et/ou d'un régulateur (30) dans le circuit de réglage du signal de modulation d'amplitude (AM) en fonction de la puissance d'émission moyenne réglée.

**16.** Procédé selon la revendication 15, **caractérisé en ce que** les paramètres comprennent l'amplification et/ou la réponse fréquentielle.

**17.** Procédé selon l'une quelconque des revendications 1 à 16, **caractérisé en ce que** la comparaison d'une valeur réelle et d'une valeur de consigne s'effectue dans la boucle de réglage du signal de modulation d'amplitude dans une échelle logarithmique.

**18.** Procédé selon la revendication 17, **caractérisé en ce que** la valeur différentielle entre la valeur réelle et la valeur de consigne pour l'activation de l'amplificateur est multipliée avec une valeur déduite de la puissance d'émission de consigne ou de la puissance d'émission moyenne de consigne.

**19.** Circuit d'émission pour générer un signal d'émission (RFM) modulé en amplitude avec une puissance d'émission moyenne réglable comprenant un amplificateur d'émission (1),
avec des moyens (8, 9, 30, 33, 34) pour générer un signal de modulation d'amplitude (AM), qui sont conçus et/ou disposés de telle sorte que le signal de modulation d'amplitude (AM) s'applique sur une entrée (3) de l'amplificateur d'émission (1), et
avec une boucle de réglage pour le réglage du signal de modulation d'amplitude (AM) avec des moyens (4, 40) pour la réinjection d'une partie (RR) du signal d'émission (RFM) modulé en amplitude pour le réglage,
la boucle de réglage présentant des moyens (5) pour atténuer la partie réinjectée du signal d'émission en fonction d'une puissance d'émission moyenne souhaitée,
**caractérisé en ce que**,
les moyens pour générer présentent des moyens (30) pour l'adaptation d'une amplification et/ou d'une réponse fréquentielle (30) en fonction de la puissance d'émission moyenne souhaitée.

**20.** Circuit d'émission selon la revendication 19, **caractérisé par** un élément d'atténuation (5) variable ou une combinaison de composants (5, 10) d'atténuation et d'amplification, dont au moins un est réglable.

**21.** Circuit d'émission selon la revendication 19 ou 20, **caractérisé par** un élément de dissociation avec atténuation variable pour la dissociation d'une partie de signal d'émission.

**22.** Circuit d'émission selon la revendication 20 ou 21, **caractérisé en ce que** l'élément d'atténuation ou le composant réglable ou l'élément de dissociation présente plusieurs niveaux de réglage.

**23.** Circuit d'émission selon l'une quelconque des revendications 19 à 22, **caractérisé par** une boucle de réglage d'atténuation pour le réglage de l'atténuation du signal réinjecté.

**24.** Circuit d'émission selon l'une quelconque des revendications 19 à 23, **caractérisé par** un coupleur directif (4) pour la dissociation de la partie (RR) du signal d'émission (RFM) pour le réglage.

**25.** Circuit d'émission selon l'une quelconque des revendications 19 à 24, **caractérisé en ce qu'**un signal d'entrée (RF) modulé en angle s'applique sur une première entrée (2) de l'amplificateur d'émission (1) et le signal de modulation d'amplitude (AM) s'applique sur une seconde entrée de l'amplificateur d'émission (1), de sorte que l'amplitude pour générer un signal d'émission modulé en amplitude et en angle dans l'amplificateur d'émission est modulé sur le signal d'entrée modulé en angle.

**26.** Circuit d'émission selon l'une quelconque des revendications 19 à 25, **caractérisé par** un détecteur d'enveloppante (7) pour déterminer l'amplitude du signal réinjecté.

**27.** Circuit d'émission selon l'une quelconque des revendications 19 à 25, **caractérisé par** une seconde boucle de réglage (7, 14, 15, 16, 17, 19) avec un amplificateur (14) réglable, qui règle le signal amorti réinjecté sur une valeur fixe (RW).

**28.** Circuit d'émission selon l'une quelconque des revendications 19 à 27, **caractérisé par** les moyens (30, 31, 32) pour la linéarisation d'une fonction non linéaire du circuit de réglage pour le signal de modulation d'amplitude (AM) respectivement dans une plage d'une puissance d'émission moyenne ou momentanée.

**29.** Circuit d'émission selon la revendication 28, **caractérisé en ce que** les moyens pour la linéarisation comprennent un amplificateur et/ou un régulateur (30) avec des paramètres réglables.

**30.** Circuit d'émission selon la revendication 29, **caractérisé en ce que** les moyens pour la linéarisation comprennent un régulateur PID (31) avec amplification réglable et/ou une réponse fréquentielle réglable.

**31.** Circuit d'émission selon l'une quelconque des revendications 28 à 30, **caractérisé en ce que** les moyens pour l'adaptation (30) comprennent les moyens pour la linéarisation (30, 31, 32).

**32.** Circuit d'émission selon l'une quelconque des revendications 19 à 31, **caractérisé par** des moyens pour la conversion d'une valeur réelle dans la boucle de réglage du signal de modulation d'amplitude dans une échelle logarithmique.

**33.** Circuit d'émission selon la revendication 32, **caractérisé par** des moyens pour la multiplication d'une valeur différentielle entre une valeur réelle logarithmique et une valeur de consigne logarithmique pour l'activation de l'amplificateur d'émission avec une valeur déduite de la puissance d'émission prescrite ou de la puissance moyenne d'émission de consigne.

**34.** Terminal de communication avec un circuit d'émission selon l'une quelconque des revendications 19 à 33.

# FIG 1

# FIG 2

FIG 3

EP 1 260 016 B1

# FIG 4